# EUROPEAN PATENT APPLICATION

(11) **EP 2 317 646 A1**
(43) Date of publication of application: **04.05.2011**
(21) Application number: 09252522.9
(22) Date of filing: 30.10.2009
(51) Int. Cl.: H03F 3/187, H03F 3/45

(54) **Amplifier**

(71) Applicant: ST-Ericsson SA, 1228 Plan-les-Ouates (CH)
(72) Inventor: Teng, Robert Hwat Hian, 8048 Zurich (CH)
(74) Representative: Gray, Peter John Bracey

(57) **Abstract**

An amplifier 100 has an input 108 for receiving a signal to be amplified and an output 110 for outputting an amplified signal. The amplifier 100 comprises a main amplification stage 102, an auxiliary amplification stage 104 and a controller 106. The main amplification stage 102 comprises a main amplification circuit 200 and the auxiliary amplification stage 104 comprises an auxiliary amplification circuit 202. Each of the main amplification circuit 200 and the auxiliary amplification circuit 202 comprises a p-channel metal oxide semiconductor (PMOS) transistor T1, T3 and an n-channel metal oxide semiconductor (NMOS) transistor T2, T4. The PMOS and NMOS transistors T3, T4 of the auxiliary amplification circuit 202 are either identical to the PMOS and NMOS transistors T1, T2 of the main amplification circuit 200 or are scaled down copies of the PMOS and NMOS transistors T1, T2 of the main amplification circuit 200. The auxiliary amplification circuit 202 amplifies the input signal to generate a control signal and the controller 106 controls a function of the amplifier 100 based on the control signal.

## Description

The present disclosure relates to generation of a control signal for controlling a function of an amplifier. It is particularly, but not exclusively, applicable to an audio amplifier of a mobile communications device or portable personal music player.

### Background to the Disclosure

In a mobile communications device or portable personal music player, as well as in many other applications, it is desirable to minimise the size of an amplifier. In particular, when an amplifier is implemented in an integrated circuit, it is desirable to minimise the area of silicon occupied by the amplifier.

As well as the components, in particular the transistors, that contribute directly to amplification of a signal, audio amplifiers usually comprise various components and circuits associated with control of the audio amplifier. For example, a variable gain stage may have a circuit for identifying a time at which an audio signal to be amplified has a zero value, so that it can vary the gain at this time to avoid glitches in the amplified signal. A DC offset correction circuit may have a comparator for detecting a DC level in the amplified signal for correction. Switches may also be provided to isolate a loudspeaker or headset from the audio amplifier whilst the audio amplifier is being activated, in order to prevent "click 'n pop" noises caused by transient signals that occur as quiescent DC voltages are established in the audio amplifier. All of these components and circuits occupy areas of silicon in the integrated circuit.

There is therefore a requirement to minimise the size of such components and circuits, or the area of silicon they occupy.

### Summary of the Preferred Embodiments

According to a first aspect, there is provided an amplifier comprising:
a main amplification stage having a main amplification circuit for amplifying an input signal;
an auxiliary amplification stage having an auxiliary amplification circuit for amplifying the input signal to generate a control signal; and
a controller for controlling a function of the amplifier based on the control signal,
wherein the auxiliary amplification circuit has the same configuration as the main amplification circuit.

By using an auxiliary amplification circuit to generate the control signal, the control signal can be generated with useful characteristics for controlling the amplifier relatively straightforwardly in comparison to the prior art. In particular, the control signal can share characteristics with a signal generated by the main amplification stage. This is achieved by the auxiliary amplification circuit being sufficiently similar to the main amplification circuit. This is achieved by the auxiliary amplification circuit having the same configuration as the main amplification circuit. Indeed, the main amplification circuit and the auxiliary amplification circuit may be substantially the same as one another.

In one example, at least one component of the auxiliary amplification circuit may have electrical characteristics that are substantially the same as the electrical characteristics of a component of the main amplification circuit. In other examples, at least one component of the auxiliary amplification circuit may have physical dimensions that are substantially the same as the physical dimensions of a component of the main amplification circuit. Whilst other parts of the two circuits may differ, if main components of each circuit are substantially the same as one another, the control signal may have characteristics in common with the signal generated by the main amplification stage.

In some examples, it may not be necessary for the auxiliary amplification circuit to be the same size as the component of the main amplification circuit in order for the control signal to have characteristics in common with the signal generated by the main amplification stage. At least one component of the auxiliary amplification circuit may be a smaller version of a component of the main amplification circuit. In particular, the component of the auxiliary amplification circuit may be smaller than the component of the main amplification circuit, e.g. by a factor of four.

Typically, the amplifier is implemented in an integrated circuit. The at least one component of the auxiliary amplification circuit may then comprise fingers substantially identical to fingers of the component of the main amplification circuit. In particular, the at least one component of the auxiliary amplification circuit may have a finger length that is substantially the same as the finger length of a component of the main amplification circuit. Any difference in the size of the two components can then be achieved by the two components having a different number of fingers. In particular, the at least one component of the auxiliary amplification circuit may have fewer fingers than the component of the main amplification circuit, e.g. a quarter of the fingers.

It is useful if the component of the auxiliary amplification circuit and the component of the main amplification circuit are matched. Accordingly, the at least one component of the auxiliary amplification circuit may be interleaved with the component of the auxiliary amplification circuit. In particular, the at least one component of the auxiliary amplification circuit may be located in the integrated circuit between two parts of the component of the main amplification circuit.

The component of the auxiliary amplification circuit and the component of the main amplification circuit may be any equivalent components of the two circuits. However, they are most usefully transistors. In particular, the main amplification circuit and the auxiliary amplification circuit each comprise an input, an output, a p-channel metal oxide semiconductor transistor with its gate coupled to the input and its drain coupled to the output, and an n-channel metal oxide semiconductor transistor with its gate coupled to the input and its drain coupled to the output. However, it should be understood that the input of each circuit may provide a different signal to each of its transistors, and can therefore be considered to be a dual or split input in some examples. It should also be understood that the outputs may be coupled to one another, and can therefore be considered to be a single common output in some examples.

In one example, the amplifier comprises a signal path including the main amplification stage, the auxiliary amplification stage is coupled to an input of the main amplification stage, the auxiliary amplification stage generates the control signal in response to a signal in the signal path at the input of the main amplification stage, the control signal being indicative of a time of a crossing of a first threshold by the signal in the signal path at an output of the main amplification stage, by generating an indication of a time of a crossing by the signal of a second threshold established by the auxiliary amplification stage, and the second threshold is substantially equal to the first threshold.

In another example, the amplifier comprises:
a signal path for a signal, the signal path including a signal processing stage and the main amplification stage; and
a switch means for, in a first state, coupling an output of the signal processing stage to an input of the main amplification stage, and, in a second state, de-coupling the output of the signal processing stage from the input of the main amplification stage,
wherein the controller, responsive to the control signal, adjusts a DC level in the signal path at a location preceding the output of the signal processing stage when the switch means is in the second state, and wherein the auxiliary amplification stage is coupled to the output of the signal processing stage and the control signal is dependent upon a DC level at the output of the signal processing stage and a DC level in the auxiliary amplification stage and indicative of a DC offset at an output of the main amplification stage (102).

In yet another example, an input of the main amplification stage and an input of the auxiliary amplification stage are coupled to a common node, an output of the main amplification stage is coupled to an output node, and the amplifier comprises:
first switch means for selectively coupling the output node to a reference voltage;
second switch means for selectively coupling power to the auxiliary amplification stage; and
third switch means for selectively coupling power to the main amplification stage,
wherein the controller is arranged to activate the amplifier by controlling the first, second and third switch means, with the second switch means initially de-coupling the power to the main amplification stage and the first switch means initially coupling the output node to the reference voltage, in the following sequential order:
controlling the second switch means to couple power to the auxiliary amplification stage and to establish a quiescent voltage at the common node, the quiescent voltage being the control signal;
in response to the control signal, controlling the third switch means to couple power to the main amplification stage; and
controlling the first switch means to de-couple the output node from the reference voltage.

### Brief Description of the Drawings

Preferred embodiments are now described, by way of example only, with reference to the accompanying drawings, in which:
Figure 1 is a schematic illustration of an amplifier;
Figure 2A and 2B are schematic illustrations of a main amplifier circuit and an auxiliary amplifier circuit of the amplifier shown in Figure 1;
Figure 3 is a schematic illustration of n-channel metal oxide semiconductor transistors of the main amplifier circuit and an auxiliary amplifier circuit shown in Figure 2;
Figure 4 is a schematic illustration of the amplifier according to a first preferred embodiment;
Figure 5 is a schematic illustration of the amplifier according to a second preferred embodiment;
Figure 6 is a schematic illustration of the amplifier according to a third preferred embodiment; and
Figure 7 is a flow chart illustrating operation of the amplifier according to the third preferred embodiment.

### Detailed Description of the Preferred Embodiments

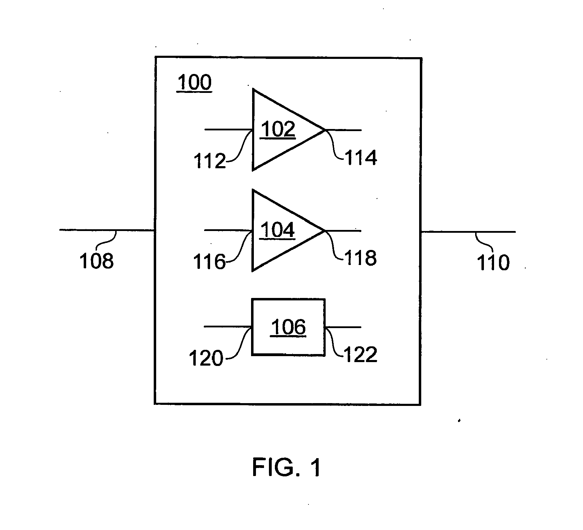

Referring to Figure 1, an amplifier 100 has an input 108 for receiving a signal to be amplified and an output 110 for outputting an amplified signal. The amplifier 100 comprises a main amplification stage 102, which has an input 112 and an output 114, and an auxiliary amplification stage 104, which also has an input 116 and an output 118.. The amplifier 100 also has a controller 106 with an input 120 and output 122. The inputs 112, 116, 120 and outputs 114, 118, 122 of the main amplification stage 102, the auxiliary amplification stage 104 and the controller 106 can be coupled in a variety of different ways and the amplifier 100 can incorporate other components not illustrated in Figure 1, as described in more detail below.

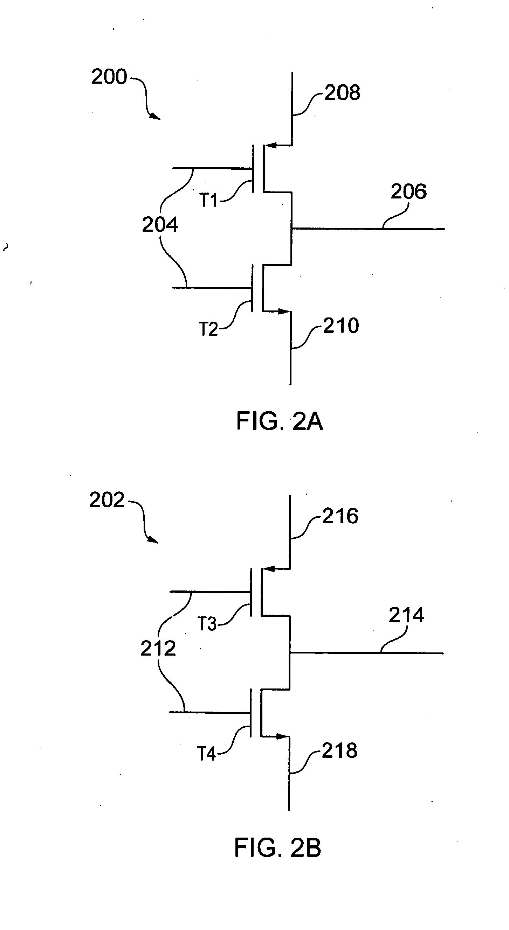

Referring to Figures 2A and 2B, the main amplification stage 102 comprises a main amplification circuit 200 and the auxiliary amplification stage 104 comprises an auxiliary amplification circuit 202. Each of the main amplification circuit 200 and the auxiliary amplification circuit 202 comprises a p-channel metal oxide semiconductor (PMOS) transistor T1, T3 and an n-channel metal oxide semiconductor (NMOS) transistor T2, T4. In each circuit 200, 202, the drains of the PMOS and NMOS transistors T1, T2, T3, T4 are coupled to an output 206, 214 of the circuit 200, 202 and the gates of the PMOS and NMOS transistors T1, T2, T3, T4 are coupled to an input 204, 212 of the circuit 200, 202. The sources 208, 216 of the PMOS transistors T1, T3 are each coupled to a supply rail (not shown) providing a first supply voltage V_{DD}, and the sources 210, 218 of the NMOS transistors T2, T4 are coupled to another supply rail (not shown) providing a relatively lower second supply voltage V_{SS}.

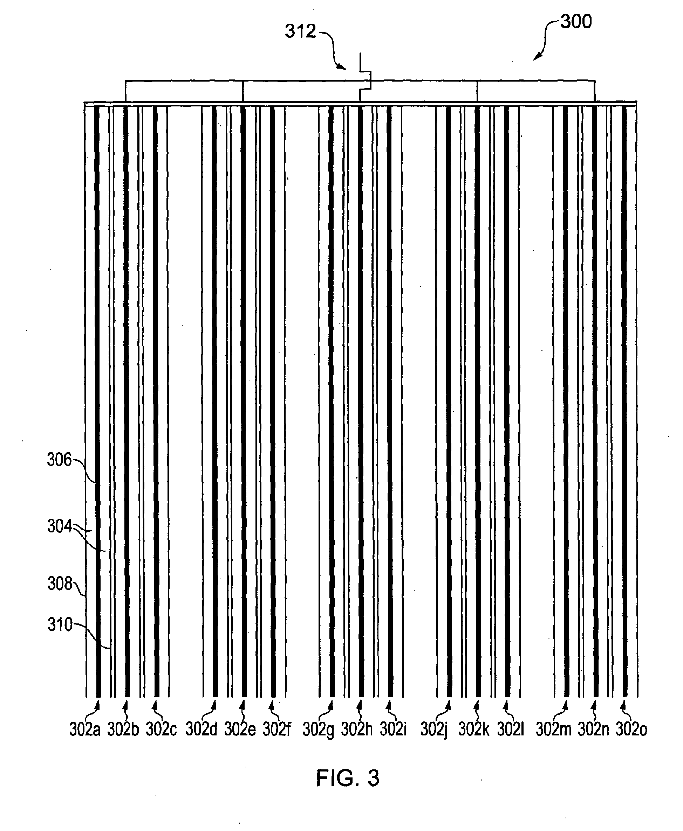

In some embodiments, the PMOS and NMOS transistors T3, T4 of the auxiliary amplification circuit 202 can be identical to the PMOS and NMOS transistors T1, T2 of the main amplification circuit 200. However, in the illustrated embodiment, the PMOS and NMOS transistors T3, T4 of the auxiliary amplification circuit 202 are smaller versions of the PMOS and NMOS transistors T1, T2 of the main amplification circuit 200. In more detail, all the PMOS and NMOS transistors T1, T2, T3, T4 are provided in an integrated circuit 300. In particular, referring to Figure 3, a region of the integrated circuit 300 in which the NMOS transistors T2, T4 are provided has a plurality fingers 302a-o, each comprising an n-type diffusion region 304 bisected by a polysilicon gate region 306. Drain and source contacts 308, 310 border the n-type diffusion regions 304 and are coupled via an interconnection circuit 312. All of the fingers 302a-o have the same length, width and construction, and the fingers 302a-o are parallel and adjacent to one another.

The NMOS transistor T2 of the main amplification circuit 200 comprises four groups of the fingers 302a-o, these groups being the three fingers 302a-c and the three fingers 302m-o at each side of the plurality of fingers 302a-o, and the three fingers 302d-f and the three fingers 302j-I immediately towards the inside of the three fingers 302a-c and the three fingers 302m-o at each side. The NMOS transistor T4 of the auxiliary amplification circuit 202 comprises the three fingers 302g-i at the centre of the plurality of fingers 302a-o. It can therefore be appreciated that the NMOS transistor T2 of the main amplification circuit 200 comprises a total of twelve of the fingers 302a-o and the NMOS transistor T4 of the auxiliary amplification circuit 202 comprises a total of three of the fingers 302a-o. The NMOS transistor T4 of the auxiliary amplification circuit 202 therefore has a quarter of the overall width of the NMOS transistor T2 of the main amplification circuit 200. The width is defined as being across the direction in which current flows in the transistors T2, T4. So, although it is coupled to the same voltage rails and therefore operates at the same voltage, the difference in width causes the NMOS transistor T4 of the auxiliary amplification circuit 202 to operate at a quarter of the current of the NMOS transistor T2 of the main amplification circuit 200. As the NMOS transistor T4 of the auxiliary amplification circuit 202 is located at the centre of the fingers making up the NMOS transistor T2 of the main amplification circuit 200, its properties are more likely to closely match those of the NMOS transistor T2 of the main amplification circuit 200, as any gradient change across the width of the plurality of fingers 302a-o is likely to be at its mid-point in the centre of the plurality of fingers 302a-o. Still better matching can be achieved by providing further fingers (not shown) at each side of the fingers 302a-o of the NMOS transistor T4 of the auxiliary amplification circuit 202 and the NMOS transistor T2 of the main amplification circuit 200, these further fingers being similar to the fingers 302a-o of the transistors T2, T4, but not being coupled to have any voltage applied to them. They may therefore be considered to be dummy fingers.

The PMOS transistor T1 of the main amplification circuit 200 and the PMOS transistor T3 of the auxiliary amplification circuit 202 are implemented in a corresponding manner in the integrated circuit 300, except that each group of the fingers of the PMOS transistors T1, T3 comprises seven fingers.

In other embodiments, the number of fingers may vary. Furthermore, the ratio of the number of fingers of the transistors T1, T2 of the main amplification circuit 200 and the number of fingers of the transistors of the auxiliary amplification circuit 202 may not be 4:1, but can instead be a different ratio, such as 5:1 or 10:1.

### First Preferred Embodiment

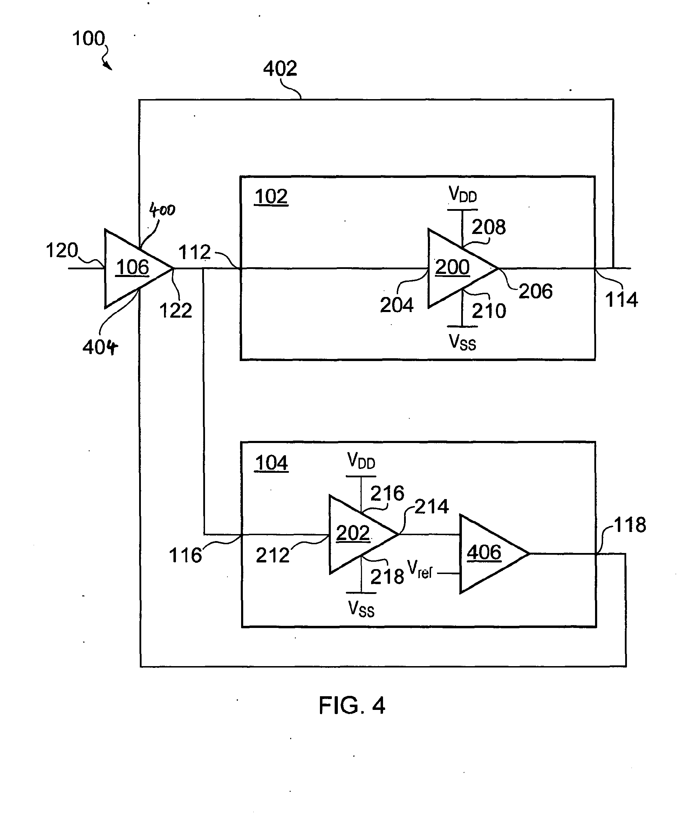

Referring to Figure 4, in a first preferred embodiment, the controller 106 is a variable gain stage and has its input 120 coupled to the input 108 of the amplifier 100. The controller 106 determines whether gain of the signal in the signal path should be increased or decreased, and also the magnitude of the gain adjustment. The output 122 of the controller 106 is coupled to the input 112 of the main stage 102 and the output 114 of the main amplification stage 102 is coupled to the output 110 of the amplifier 100. The amplifier 100 therefore comprises a signal path from the input 108 of the amplifier 100 to the output 110 of the amplifier 100 through the controller 106 and the main amplification stage 102. The signal path can include additional, non-illustrated elements preceding the controller 106, and/or between the controller 106 and the main amplification stage 102, and/or following the main amplification stage 102. In particular, driver circuitry can be provided between the output of the controller 106 and the input 204 of the main amplification circuit 200 and between the output of the controller 106 and the input 212 of the auxiliary amplification circuit 202.

In this embodiment, the output 114 of the main amplification stage 102 is coupled to another input 400 of the controller 106 by a feedback path 402. The main amplification circuit 200 has an internal gain, which together with the feedback path 402 and the controller 106 define the overall gain of the main amplification stage 102. The main amplification stage 102 has an overall gain lower than the internal gain of the main amplification circuit 200, and provides linear amplification of the signal in the signal path.

The auxiliary amplification stage 104 has its input 116 coupled to the input 112 of the main amplification stage 102. The auxiliary amplification stage 104 generates the control signal and has its output 118 coupled to yet another input 404 of the controller 106 for delivering the control signal to the controller 106. Although the auxiliary amplification stage 104 receives the signal output by the controller 106, being coupled to the input 112 of the main amplification stage 102, it does not deliver a signal to the output 110 of the amplifier 100 and is not considered to be part of the signal path.

In operation, in the main amplification circuit 200, if the gate voltages of the transistors T1, T2 are driven such that the PMOS transistor T1 conducts more current than the NMOS transistor T2, then the excess current will flow from the main amplification circuit 200 to any load coupled to the output 206 of the main amplification circuit 200. Conversely, if the gate voltages of the transistors T1, T2 of the main amplification circuit 200 are driven such that the NMOS transistor T2 conducts more current than the PMOS transistor T1, then the excess current will flow into the main amplification circuit 200 from the load coupled to the output 206 of the main amplification circuit 200.

In the absence of a signal in the signal path, the signal path is at a quiescent DC level. Due to circuit imperfections, the quiescent DC level may be different in different regions of the signal path, dependent on DC offsets introduced by different elements along the signal path, and the optimum time at which to adjust the gain in the signal path is dependent on the region where the detrimental effect of an abrupt change of gain is to be suppressed. In particular, in order to avoid an abrupt change in the signal at the output 114 of the main amplification stage 102, which, for an audio signal, may cause an undesired click at the output 110 the amplifier 100, the gain of the controller 106 should ideally be changed when the signal at the output 114 of the main amplification stage 102 crosses the quiescent DC level at that output 114. The quiescent DC level at that output 114 is referred to as the first threshold. If the auxiliary amplification stage 104 were to be coupled to the output 114 of the main amplification stage 102, instead of to the input 112 of the main amplification stage 102, the auxiliary amplification stage 104, in order to not introduce any significant perturbation to the detected crossing time, would be required to have a detection threshold closely matched to the quiescent DC level at that point and should not introduce any additional DC offset. However, an auxiliary amplification stage with near zero DC offset is costly in terms of silicon area and power.

In the amplifier 100 illustrated in Figure 4, the auxiliary amplification stage 104 is instead coupled to the input 112 of the main amplification stage 102, and it detects the crossing of a second threshold, where the second threshold is arranged in the auxiliary amplification stage 102 to be substantially equal to the first threshold. In this arrangement, it is not necessary for the auxiliary amplification stage 104 to provide zero DC offset, and instead it can have a DC offset the same as, or similar to, that of the main amplification stage 102. In this way, the auxiliary amplification stage 104 can generate a control signal indicative of the time of a crossing of the first threshold by the signal in the signal path at the output 114 of the main amplification stage 102 without being coupled to that output 114.

For the auxiliary amplification stage 104 under the same drive conditions as the main amplification stage 102, but operated open loop without feedback and unloaded, or with a high impedance load, if the gate voltages of the NMOS and PMOS transistors T3, T4 of the auxiliary amplification circuit 202 are driven such that the PMOS transistor T3 tries to conduct more current than the NMOS transistor T4, the drain-source voltage of the PMOS transistor T3 is small and the voltage at the output 214 of the auxiliary amplification circuit 202 is close to the first supply voltage V_{DD} to which source of the PMOS transistor T3 is coupled. Conversely, if the gate voltages of the transistors T3, T4 are driven such that the NMOS transistor T4 tries to conduct more current than the PMOS transistor T4, the drain-source voltage of the NMOS transistor T4 is small and the voltage at the output 214 of the auxiliary amplification circuit 22 is close to the second supply voltage V_{SS} to which the source of the NMOS transistor T4 is coupled.

In the auxiliary amplification stage 104, the auxiliary amplification circuit 202 has its output 214 coupled to a first input of a comparator 406. The comparator 406 has a second input for a reference voltage V_{ref}. An output of the comparator 406 is coupled the output 118 of the auxiliary amplification stage 104. The auxiliary amplification circuit 202 is not provided with feedback, and so amplifies with a gain equal to its internal gain, which is relatively high. This causes limiting of the signal passing through the auxiliary amplification circuit 202, such that the signal at the output 210 of the auxiliary amplification circuit 202 is substantially a two-level signal having fast transitions between supply voltage rails of the auxiliary amplification circuit 202. The transitions are indicative of whether the signal at the input 212 of the auxiliary amplification circuit 202 is above or below a quiescent DC level in the auxiliary amplification circuit 202, that is the second threshold, this being the quiescent DC level in the auxiliary amplification circuit 202 in the absence of a signal at the input 108 of the amplifier 100. Because the auxiliary amplification circuit 202 is similar to the main amplification circuit 200, the DC offset level of the auxiliary amplification circuit 202 is substantially equal to the DC offset level of the main amplification circuit 200, and therefore the second threshold is substantially equal to the first threshold.

The comparator 406 functions as a buffer to provide the control signal in a binary format suitable for use by the controller 106, but may be omitted if the signal at the output 210 of the auxiliary amplification circuit 202 is suitable for use directly by the controller 106. The comparator 406 may be, for example, a digital inverter. The control signal is therefore indicative of whether the signal at the output 214 of the auxiliary amplification circuit 202 is above or below the quiescent DC level that would be present at the output 110 of the amplifier 100 in the absence of a signal at the input 108 of the amplifier 100. Because signal at the output 210 of the auxiliary amplification circuit 202 is a substantially two-level signal with fast transitions, it is not essential for the comparator 406 to have a low DC offset or for the reference voltage V_{ref} to have a precise value as deviations in these will not cause a time shift in the transitions of the control signal.

Under ideal operating conditions, in order to avoid introducing abrupt changes into the signal at the output 110 of the amplifier 100, the time of the change of gain in the controller 106 coincides with the time of a transition in the control signal, and therefore coincides with the time at which the signal at the output 110 of the amplifier 100 crosses the quiescent DC level at that output 110. However, in practice there is likely to be a finite delay between the detection of a crossing and the change of the gain. Nevertheless, it is desirable to synchronise changes of gain with the time of the crossing in the signal, even though the synchronisation may not provide coincidence, and to minimise the delay between the detection of a crossing and the change of the gain.

### Second Preferred Embodiment

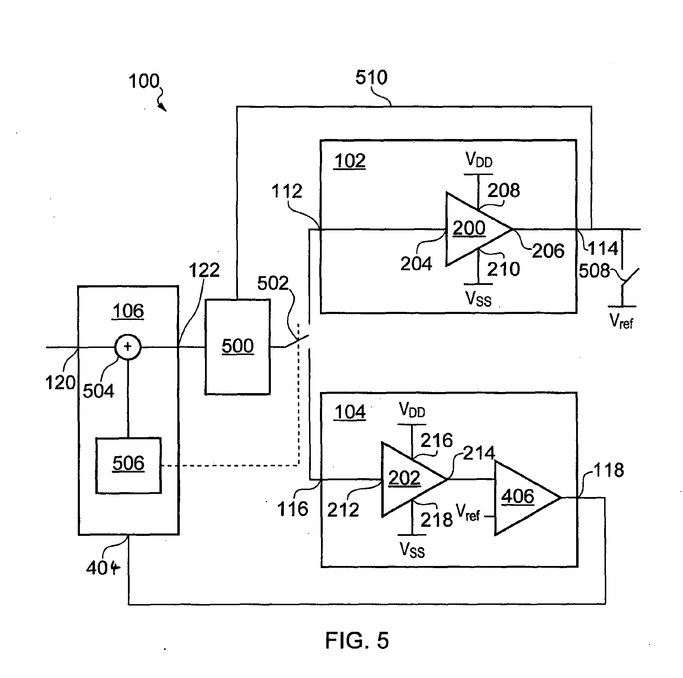

Referring to Figure 5, in a second preferred embodiment, the controller 106 is a calibration stage with its input 120 coupled to the input 108 of the amplifier 100 and its output 122 coupled to the input 112 of the main amplification stage 102 via a signal processing stage 500 followed by a routing switch 502. The output 114 of the main amplification stage 102 is coupled to the output 110 of the amplifier 100. The amplifier 100 therefore comprises a signal path from the input 108 of the amplifier 100 to the output 110 of the amplifier 100 through the controller 106, the signal processing stage 500, routing switch 502 and the main amplification stage 102.

The feedback path 402 of the first preferred embodiment is replaced, in the second embodiment, with a feedback path 510 coupled from the output 114 of the main amplification stage to another input of the signal processing stage 500. The output 114 of the main amplification stage 102 is also coupled to the reference voltage V_{ref} via an output switch 508. The reference voltage V_{ref} is chosen such that no, or very little, current flows into or out of the output 114 during calibration. Typically, the reference voltage V_{ref} is the average of the first and second supply voltages V_{DD}, V_{SS}, or V_{DD}+V_{SS}/2.

In this embodiment, the auxiliary amplification stage 104 is coupled in the same way as in the first preferred embodiment, except that it has its input 116 coupled to the output of the signal processing stage 500 via the routing switch 502. The routing switch 502 can selectively route the signal from the output of the signal processing stage 500 to either the input 112 of the main amplification stage 102 or the input 116 of the auxiliary amplification stage 104. The amplifier 100 is operated in a first mode, which is referred to as a calibration mode, without a signal received at the input 120 of the controller 106, and in a second mode, which is referred to as a normal operation mode, with a signal received at the input 120 of the controller 106.

The controller 106 comprises a summing stage 504 for summing the signal received at the input 120 of the controller 106 with a DC level generated by a calibration controller 506 in response to the control signal received at the other input 404 of the controller 400, although no signal is applied at the input 120 of the controller 404 during the calibration mode.

The auxiliary amplification circuit 202 is again operated without feedback and has a relatively high gain such that it operates as a comparator, delivering at its output 214 a voltage corresponding to the first supply voltage V_{DD} or the second supply voltage V_{SS} respectively, according to whether the DC level at the input 212 of the auxiliary amplification circuit 202 is above or below the DC offset of the circuit 202. The output of the auxiliary amplification circuit 202 is coupled to the comparator 406. The comparator 406 has a second input for a reference voltage V_{ref}. The output of the comparator 406 is coupled the output 118 of the auxiliary amplification stage 104 and delivers the control signal as a binary signal dependent on whether the voltage at the output of the auxiliary amplification circuit 202 is above or below the reference voltage V_{ref}. As the voltage at the output of the auxiliary amplification circuit 202 has fast transitions between the upper or lower voltage rails, the value of the reference voltage V_{ref} need not be established with a high degree of precision as a deviation in the value of the reference voltage V_{ref} does not cause significant deviation in the time of transitions at the output of the comparator 406, and therefore does not introduce a significant error into the indication by the control signal of whether the voltage at the input 212 is above or below the DC offset level of the auxiliary amplification circuit 202. The comparator 406 functions as a buffer to provide the control signal in a binary format suitable for use by the controller 106, but may be omitted if the signal at the output 214 of the auxiliary amplification circuit 202 is suitable for use directly by the controller 106.

In the calibration mode, the controller 106 controls the routing switch 502 to couple the output of the signal processing stage 500 to the input 116 of the auxiliary amplification stage 104 and controls the output switch 508 to couple the output 114 of the main amplification stage 102 to the reference voltage V_{ref} to ensure that reference voltage V_{ref} is coupled to the feedback path 510. In this mode, the DC level at the input 116 of the auxiliary stage 104 is dependent on the DC level at the input of the signal processing stage 500 and the DC offset of the signal processing stage 500. The auxiliary amplification stage 104 generates the control signal dependent on the DC level at its input 116 and a DC level in the auxiliary stage 104. In response to the control signal, the controller 106 adjusts the DC level in the signal path preceding the output of the signal processing stage 500 in order to reduce deviation from a desired value of the DC level in auxiliary amplification stage 104. More specifically, when the control signal indicates that the DC level in the auxiliary amplification stage 104 has reached the desired value, the controller 106 controls the routing switch 502 to couple the output of the signal processing stage 500 to input 112 of the main amplification stage 102, and then controls the output switch 508 to de-couple the output 114 of the main amplification stage 102 from the reference voltage V_{ref}. In this state, the calibration mode ceases and the normal operation mode commences, with the signal received at the input 120 of the controller 106 passing along the signal path of the amplifier 100 and being delivered at the output 114 of the main amplification stage 102. The calibration can be repeated whenever desired to take account of variations in DC levels, for example, at power-on or after temperature changes, or in the absence of a signal to be processed.

Any DC offset introduced by the main amplification stage 102 does not affect the control signal during the calibration mode, so is not taken into account during the calibration process. However, the DC level in the auxiliary amplification stage 104 does affect the control signal and so is taken into account during the calibration process. Therefore, the adjustment of the DC level in the signal path is performed with the main amplification stage 102 replaced by the auxiliary amplification stage 104. If the DC level in the auxiliary amplification stage 104 is indicative of the DC offset of the main amplification stage 102, the DC level adjustment made during the calibration mode is valid during the normal operation mode with the main amplification stage 104 restored to the signal path. In this way, it is not necessary for the auxiliary amplification stage 104 to have a very small effect on the DC level; a larger effect on the DC level is acceptable provided it is sufficiently indicative of the DC offset of the main amplification stage 102 to provide an acceptable calibration. The degree of similarity desirable between the DC offset of the main amplification stage 102 and the effect of the auxiliary amplification stage 104 on the DC level is dependent on the application. However, in some applications, it is preferable that the effect of the auxiliary amplification stage 104 on the DC level is substantially identical to the DC offset of the main amplification stage 102. Because the auxiliary amplification circuit 202 is similar to the main amplification circuit 200, the effect of the auxiliary amplification stage 104 on the DC level can be substantially equal to the DC offset of the main amplification stage 102.

### Third Preferred Embodiment

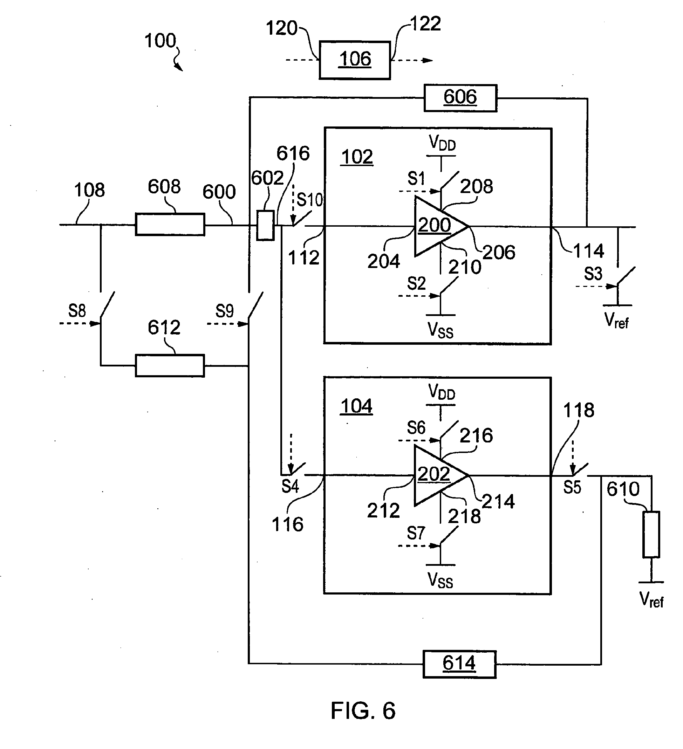

Referring to Figure 6, in a third embodiment, the main amplification stage 102 and the auxiliary amplification stage 104 have their inputs 112, 116 coupled via a common node 616 to an input stage 602. The purpose of the input stage 602 is to provide a signal suitable for driving the main amplification stage 102 and, if desired, to amplify the signal. However, in other embodiments, the input stage 602 can be omitted.

The drains and sources of the PMOS and NMOS transistors T1, T2 of the main amplification circuit 102 are respectively coupled to the first supply rail supplying the first supply voltage V_{DD} by means of a first switch S1, and to the second supply rail supplying the relatively lower second supply voltage V_{SS} by.means of a second switch S2. The output 114 of the main amplification stage 102 is coupled to the reference voltage V_{ref} by means of a third switch S3. The reference voltage V_{ref} is, in this embodiment, equal to (V_{DD}+V_{SS})/2, or at least close to this value. A first resistive element 606 is coupled between the output 114 of the main amplification stage 102 and an input of the input stage 602 via intermediate node 600. In addition, coupled between the input 108 of the amplifier 100 and the input to the input stage 602 via the intermediate node 600 is a second resistive element 608.

The input 116 of the auxiliary amplification stage 104 is coupled to an output of the input stage 602 via the common node 616 by means of a fourth switch S4 and the input 112 of the main amplification stage 102 is coupled to the output of the input stage 602 via the common node 616 by means of a tenth switch S10. The output 118 of the auxiliary amplification stage 104 is coupled via means of a fifth switch S5 to the reference voltage V_{ref} via an auxiliary load 610. The use of the auxiliary load 610 is optional, but it may improve the performance of the amplifier 100 by reducing fluctuations in voltage at the output 118 of the auxiliary amplification stage 104, and consequently reduce fluctuations in voltage at the common node 600. Alternatively, the output 118 of the auxiliary amplification stage 104 need not be coupled to the reference voltage V_{ref}. If used, the auxiliary load 610 may be chosen to have impedance equal to the impedance of the load to be coupled to the output 114 of the main amplification stage 102, taking into account the scaling of the auxiliary amplification circuit 202, so in this embodiment being four times the impedance of the load to be coupled to the output 114 of the main amplification stage 102.

The auxiliary amplification stage 104 is coupled to the first supply rail supplying the first supply voltage V_{DD} by means of a sixth switch S6, and to the second supply rail supplying the second supply voltage V_{SS} by means of a seventh switch S7. A third resistive element 612 has a first terminal coupled to the input 108 of the amplifier 100 by means of an eighth switch S8, and a second terminal coupled to the common node 600 by means of a ninth switch S9. A fourth resistive element 614 has a first terminal coupled to the second terminal of the third resistive element 612, and a second terminal coupled to the output 118 of the auxiliary amplification stage 104 via the fifth switch S5. In this embodiment, the second resistive element 608 and the third resistive element 612 have equal resistance, and the first resistive element 606 and the fourth resistive element 614 have equal resistance. In other embodiments, non-equal resistances can be used.

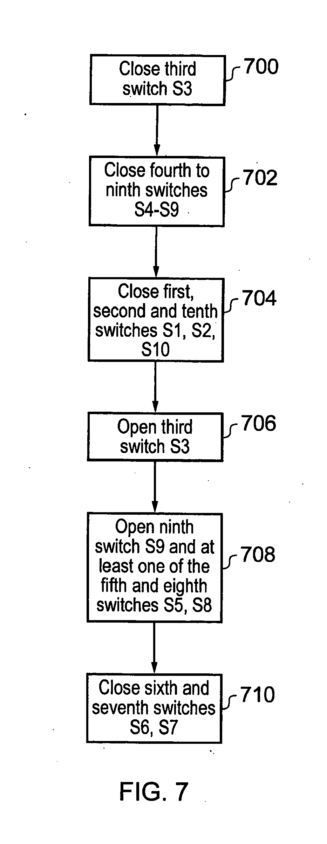

The controller 106 controls the first to tenth switches S1-S10. Referring to Figure 7, activation, or powering up, of the amplifier 100 begins from an initial state in which the first to tenth switches S1-S10 are open, that is, in a non-conducting state. At step 700, the controller 106 closes the third switch S3, thereby coupling the output of the main amplification stage 102 to the reference voltage V_{ref}. At step 702, the controller 70 closes fourth to ninth switches S4-S9, resulting in power being applied to the auxiliary amplification stage 104 from the supply rails supplying the first and second supply voltages V_{DD} and V_{SS} Consequently, current flows in the auxiliary amplification stage 104 and in the third and fourth resistive elements 612, 614, and a quiescent voltage is established at the common node 600. At this time, the auxiliary amplification stage 104 and the sixth resistive element 614 are operating in a first feedback loop.

The input 120 of the controller 106 is arranged to determine when the quiescent voltage has been established and the quiescent voltage therefore constitutes the control signal. In response to the control signal, at step 704, the controller 106 closes the first, second and tenth switches S1, S2, S10. This results in power being applied to the main amplification stage 102 from the supply rails supplying the first and second supply voltages V_{DD} and V_{SS}. Due to the auxiliary amplification stage 104 being similar to the main amplification stage 102, and the equality of the second and third resistive elements 608, 612 and of the first and fourth resistive elements 606, 614, the main amplification stage 102 and the first and second resistive elements 606, 608 will tend to establish the same quiescent voltage at the common node 600 as already established by the auxiliary amplification stage 104 in conjunction with the third and fourth resistive elements 612, 614. In practice, there may be a transient voltage as the main amplification stage 102 starts to conduct current due to, for example, mismatch of transistor parasitic capacitance or load in the main amplification stage 102. However, this transient voltage is at least minimal due to the third switch S3 coupling the output 114 of the main amplification stage 102 to the reference voltage V_{ref}.

At step 706, the controller 106 opens the third switch S3. At this time, the main amplification stage 102 and the first resistive element 606 are operating in a second feedback loop, simultaneously to the operation of the first feedback loop of the auxiliary amplification stage 104 and the fourth resistive element 614.

At step 708, the controller 106 breaks the first feedback loop by opening the ninth switch S9, to prevent the first feedback loop from affecting the subsequent operation of the main amplification stage 102. In addition at step 708, to avoid the third and fourth resistive elements 612, 614 affecting the subsequent operation of the main amplification stage 102, the controller 106 opens at least one of the fifth and eighth switches S5, S8. Indeed, in another embodiment, either the fifth switch S5 or the eighth switch S8 may be omitted, being replaced by a direct coupling, equivalent to maintaining one of the fifth and eighth switches S5, S8 in the closed position. In this state, the amplifier 100 is able to amplify in the main amplification stage 102 signals received at the input 108 of the amplifier 100 and deliver the amplified signal at the output 108 of the amplifier 100, although this is also possible after step 706 if the auxiliary load 610 is equal to the load at the output 114 of the main amplification stage 102 and if the auxiliary amplification stage 104 is equal to the main amplification stage 102.

At this time, it is advantageous to proceed to deactivate the auxiliary amplification stage 104 in order to reduce power consumption. Therefore, at optional step 710, controller 106 opens the sixth and seventh switches S6, S7 so that the auxiliary amplification stage 104 is de-coupled from the first and second supply rails. In addition, to avoid the auxiliary amplification stage 104 affecting the operation of the main amplification stage 102, the controller 106 opens the tenth switch S10.

The similarity of the main amplification circuit 200 and auxiliary amplification circuit 200 means that the quiescent operating voltage established at the common node 600 by the auxiliary amplifier circuit 202 is equal to the quiescent operating voltage at the common node 600 when main amplification circuit 200 is operational, delivering an amplified signal to the load coupled to the output 114 of the main amplification stage 102. This enables transient signals at the output 114 to be minimised. Even the use of an auxiliary amplifier circuit 202 that is not very similar to the main amplifier circuit 200 can provide a quiescent operating voltage at the common node 600 that will contribute to reducing the occurrence of transients at the output 114.

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable subcombination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that the Figures are not necessarily to scale; emphasis instead generally being placed upon illustrating the principles of the present invention.

## Claims

1. An amplifier (100) comprising:
a main amplification stage (102) having a main amplification circuit (200) for amplifying an input signal;
an auxiliary amplification stage (104) having an auxiliary amplification circuit (202) for amplifying the input signal to generate a control signal; and
a controller (106) for controlling a function of the amplifier (100) based on the control signal,
wherein the auxiliary amplification circuit (202) has the same configuration as the main amplification circuit (200).

2. An amplifier (100) as claimed in claim 1, wherein at least one component of the auxiliary amplification circuit (202) has electrical characteristics that are substantially the same as the electrical characteristics of a component of the main amplification circuit (200).

3. An amplifier (100) as claimed in claim 1 or claim 2, wherein (the) at least one component of the auxiliary amplification circuit (202) has physical dimensions that are substantially the same as the physical dimensions of at the component of the main amplification circuit (200).

4. An amplifier (100) as claimed in claim 1, wherein at least one component of the auxiliary amplification circuit (202) is a smaller version of a component of the main amplification circuit (200).

5. An amplifier (100) as claimed in claim 4, wherein at least one component of the auxiliary amplification circuit (202) is smaller than the component of the main amplification circuit (200) by a factor of four.

6. An amplifier (100) as claimed in any one of the preceding claims, implemented in an integrated circuit (300).

7. An amplifier (100) as claimed in claim 6, wherein the at least one component of the auxiliary amplification circuit (202) has a finger length that is substantially the same as the finger length a component of the main amplification circuit (200).

8. An amplifier (100) as claimed in claim 6 or claim 7, wherein the at least one component of the auxiliary amplification circuit (202) is located in the integrated circuit (300) between two parts of the component of the main amplification circuit (200).

9. An amplifier (100) as claimed in any one of claims 2 to 8, wherein the components are transistors (T1, T2, T3, T4).

10. An amplifier (100) as claimed in any one of the preceding claims, wherein the main amplification circuit (200) and the auxiliary amplification circuit (202) each comprise an input (204, 212), an output (206, 214), a p-channel metal oxide semiconductor transistor (T1, T3) with its gate coupled to the input (204, 212) and its drain coupled to the output (206, 214), and an n-channel metal oxide semiconductor transistor (T2, T4) with its gate coupled to the input (204, 212) and its drain coupled to the output (206, 214).

11. An amplifier (100) as claimed in any one of the preceding claims, comprising a signal path including the main amplification stage (102) and wherein the auxiliary amplification stage (104) is coupled to an input (112) of the main amplification stage (102), the auxiliary amplification stage (104) generates the control signal in response to a signal in the signal path at the input (112) of the main amplification stage (102), the control signal being indicative of a time of a crossing of a first threshold by the signal in the signal path at an output (114) of the main amplification stage (102), by generating an indication of a time of a crossing by the signal of a second threshold established by the auxiliary amplification stage (104), and the second threshold is substantially equal to the first threshold.

12. An amplifier (100) as claimed in any one of claims 1 to 10, comprising: a signal path for a signal, the signal path including a signal processing stage (500) and the main amplification stage (102); and
a switch means (502) for, in a first state, coupling an output of the signal processing stage (500) to an input (112) of the main amplification stage (102), and, in a second state, de-coupling the output of the signal processing stage (500) from the input (112) of the main amplification stage (102),
wherein the controller (106), responsive to the control signal, adjusts a DC level in the signal path at a location preceding the output of the signal processing stage (500) when the switch means (502) is in the second state, the auxiliary amplification stage (104) is coupled to the output of the signal processing stage (500), and the control signal is dependent upon a DC level at the output of the signal processing stage (500) and on a DC level in the auxiliary amplification stage (104) and indicative of a DC offset at an output of the main amplification stage (102).

13. An amplifier (100) as claimed in any one of claims 1 to 10, wherein an input (112) of the main amplification stage (102) and an input (116) of the auxiliary amplification stage (104) are coupled to a common node (616), and an output (114) of the main amplification stage (102) is coupled to an output node, the amplifier (100) comprising:
first switch means (S3) for selectively coupling the output node to a reference voltage (V_{ref});
second switch means (S6, S7) for selectively coupling power to the auxiliary amplification stage (104); and
third switch means (S1, S2) for selectively coupling power to the main amplification stage (102),
wherein the controller (106) is arranged to activate the amplifier (100) by controlling the first, second and third switch means (S1, S2, S3, S6, S7), with the second switch means (S6, S7) initially de-coupling the power to the main amplification stage (102) and the first switch means (S3) initially coupling the output node to the reference voltage (V_{ref}), in the following sequential order:
controlling the second switch means (S6, S7) to couple power to the auxiliary amplification stage (104) and to establish a quiescent voltage at the common node (600);
controlling the third switch means (S1, S2) to couple power to the main amplification stage (102); and
controlling the first switch means (S3) to de-couple the output node from the reference voltage (V_{ref}).
